# EUROPEAN PATENT SPECIFICATION

(11) **EP 4 354 979 B1**
(45) Date of publication and mention of the grant of the patent: **18.03.2026**
(21) Application number: 23203494.2
(22) Date of filing: 13.10.2023
(51) Int. Cl.: H04W 52/14, H04W 72/044, H04W 52/36, H04L 5/00, H04W 52/50, H04W 52/24, H03M 1/00, H03M 1/12

(54) **CLIENT DEVICE AND NETWORK NODE DEVICE**
CLIENT-VORRICHTUNG UND NETZWERKKNOTEN-VORRICHTUNG
DISPOSITIF CLIENT ET DISPOSITIF DE NOEUD DE RÉSEAU

(30) Priority: 14.10.2022 FI 20225936
(43) Date of publication of application: 17.04.2024
(73) Proprietor: Nokia Technologies Oy, 02610 Espoo (FI)
(72) Inventor: ATZENI, Italo, Oulu (FI); ARVOLA, Antti, Oulu (FI); GOUDA, Bikshapathi, Oulu (FI); TÖLLI, Antti, Oulu (FI); KARJALAINEN, Juha Pekka, Sotkamo (FI); HAKOLA, Sami-Jukka, Kempele (FI); KOSKELA, Timo, Oulu (FI)
(74) Representative: Papula Oy

(56) References cited:
- US-A1- 2009 175 228
- LIU TIANLE ET AL: "Energy Efficiency of Massive MIMO Systems With Low-Resolution ADCs and Successive Interference Cancellation", IEEE TRANSACTIONS ON WIRELESS COMMUNICATIONS, IEEE SERVICE CENTER, PISCATAWAY, NJ, US, vol. 18, no. 8, 1 August 2019 (2019-08-01), pages 3987 - 4002, XP011739427, ISSN: 1536-1276, [retrieved on 20190809], DOI: 10.1109/TWC.2019.2920129

## Description

### TECHNICAL FIELD

The present application generally relates to the field of wireless communications. In particular, the present application relates to a client device, a network node device, and related methods and computer programs.

### BACKGROUND

To support the exponential growth in mobile data traffic and meet the quality-of-service requirements of emerging wireless applications, such as autonomous mobility and augmented/mixed reality, beyond-5G systems are expected to exploit the large amount of bandwidth available in the sub-THz band. This calls for truly massive arrays with thousands of fully digital antennas at the gNB. In this setting, the power consumed by each analog-to-digital/digital-to-analog converter (ADC/DAC) scales linearly with the sampling rate and exponentially with the number of quantization bits. Another limiting factor is the volume of raw data exchanged between the remote radio head and the base-band unit, which scales linearly with both the sampling rate and the number of quantization bits. For these reasons, adopting low-resolution ADCs/DACs with 1 to 4 quantization bits represents an attractive solution to drastically reduce the hardware power consumption and complexity at mmWave and sub-THz frequencies. Even with few-bit data converters, fully digital architectures can outperform their hybrid analog-digital counterparts in terms of flexibility and energy efficiency and allow to achieve the large array and multiplexing gains promised by massive multiple-input multiple-output (MIMO).

Publication "Energy Efficiency of Massive MIMO Systems With Low-Resolution ADCs and Successive Interference Cancellation" by Liu Tianle et al. studies the influence of signal detection schemes on the energy efficiency of uplink multiple-input-multiple-output (MIMO) systems with low-resolution analog-to-digital converters (ADCs). Assuming equal transmission rates for all users, the optimal power allocation and their analytical approximations for zero-forcing (ZF) and ZF successive interference cancellation (ZF-SIC) receivers is derived. Both the cases with perfect channel state information (CSI) and with imperfect CSI are considered. The EE with different receivers is compared. The results indicate that for uplink massive MIMO systems with low-resolution ADCs, the radio-frequency circuit power consumption can be significant because a large number of antennas are required to compensate for the loss due to quantization errors while the number of base station antennas needed with the ZF-SIC receiver is significantly smaller than that with the ZF receiver.

### SUMMARY

The scope of protection sought for various example embodiments is set out by the independent claims. The example embodiments and features, if any, described in this specification that do not fall under the scope of the independent claims are to be interpreted as examples useful for understanding various example embodiments.

An example embodiment of a client device comprises means for performing: obtain a signal sequence configuration defining a plurality of signal sequences, wherein each signal sequence in the plurality of signal sequences corresponds to an uplink transmission power level in a plurality of uplink transmission power levels; transmit the plurality of signal sequences according to the signal sequence configuration to a network node device; receive, from the network node device, an indication about an uplink transmission power level out of the plurality of uplink transmission power levels to be used for uplink transmission; and perform an uplink transmission using the indicated uplink transmission power level to the network node device.

In an example embodiment, alternatively or in addition to the above-described example embodiments, the plurality of signal sequences are interleaved and/or concatenated with each other. The client device can, for example, efficiently transmit the plurality of signal sequences.

In an example embodiment, alternatively or in addition to the above-described example embodiments, each signal sequence in the plurality of signal sequences corresponds to an amplitude-scaled version of a common signal sequence. The client device can, for example, efficiently generate the plurality of signal sequences.

In an example embodiment, alternatively or in addition to the above-described example embodiments, the uplink transmission corresponds to a channel, a channel associated with data, a channel associated with control, a signal, a reference signals, and/or any combination thereof. The client device can, for example, efficiently transmit any of the above using an appropriate uplink transmission power level.

In an example embodiment, alternatively or in addition to the above-described example embodiments, the at least one memory and the computer program code are further configured to, with the at least one processor, cause the client device to transmit the plurality of signal sequences in a physical random access channel preamble. The client device can, for example, efficiently transmit the plurality of signal sequences.

In an example embodiment, alternatively or in addition to the above-described example embodiments, the at least one memory and the computer program code are further configured to, with the at least one processor, cause the client device to transmit the plurality of signal sequences according to the signal sequence configuration to the network node device at predefined transmission time occasions. The client device can, for example, transmit the plurality of signal sequences without needing to wait for signaling from the network node device.

In an example embodiment, alternatively or in addition to the above-described example embodiments, the at least one memory and the computer program code are further configured to, with the at least one processor, cause the client device to obtain the signal sequence configuration by receiving the signal sequence configuration from the network node device, and wherein the signal sequence configuration comprises an uplink transmission power range defining a minimum power and a maximum power for the plurality of signal sequences and a power ramping step for the plurality of signal sequences. The client device can, for example, efficiently determine the plurality of signal sequences based on the aforementioned parameters.

An example embodiment of a network node device comprises means for performing: receive a plurality of signal sequences from a client device, wherein each signal sequence in the plurality of signal sequences corresponds to an uplink transmission power level in a plurality of uplink transmission power levels; choose an uplink transmission power level out of the plurality of uplink transmission power levels to be used for uplink transmission based on the received plurality of signal sequences; and transmit an indication about the chosen uplink transmission power level to the client device.

In an example embodiment, alternatively or in addition to the above-described example embodiments, the at least one memory and the computer program code are further configured to, with the at least one processor, cause the network node device to choose the uplink transmission power level to be used for uplink transmission by performing: estimate each signal sequence in the plurality of signal sequences; and choose the uplink transmission power level by comparing each estimated signal sequence to a known signal sequence. The network node device can, for example, efficiently choose an appropriate uplink transmission power level.

In an example embodiment, alternatively or in addition to the above-described example embodiments, the at least one memory and the computer program code are further configured to, with the at least one processor, cause the network node device to be used for uplink transmission by performing: compute a channel estimate for the client device based on the received plurality of signal sequences; compute a combining vector for the client device based on the channel estimate of the client device; estimate each signal sequence in the plurality of signal sequences based on the combining vector of the client device; and choose the uplink transmission power level by comparing each estimated signal sequence to a known signal sequence. The network node device can, for example, efficiently choose an appropriate uplink transmission power level.

In an example embodiment, alternatively or in addition to the above-described example embodiments, the network node device further comprises at least one analog-to-digital converter with 1 - 10 quantization bits and the at least one memory and the computer program code are further configured to, with the at least one processor, cause the network node device to receive the uplink transmission from the client device using the at least one analog-to-digital converter. The network node device can, for example, efficiently choose an appropriate uplink transmission power level for such an analog-to-digital converter configuration with few bits.

In an example embodiment, alternatively or in addition to the above-described example embodiments, the at least one memory and the computer program code are further configured to, with the at least one processor, cause the network node device to: transmit a signal sequence configuration defining the plurality of signal sequences to the client device. The network node device can, for example, efficiently indicate the plurality of signal sequences to be used.

An example embodiment of a method comprises: obtaining a signal sequence configuration defining a plurality of signal sequences, wherein each signal sequence in the plurality of signal sequences corresponds to an uplink transmissions power level in a plurality of uplink transmission power levels; transmitting the plurality of signal sequences according to the signal sequence configuration to a network node device; receiving, from the network node device, an indication about an uplink transmission power level out of the plurality of uplink transmission power levels to be used for uplink transmission; and performing an uplink transmission using the indicated uplink transmission power level to the network node device.

An example embodiment of a method comprises: receiving a plurality of signal sequences from a client device, wherein each signal sequence in the plurality of signal sequences corresponds to an uplink transmission power level in a plurality of uplink transmission power levels; choosing an uplink transmission power level out of the plurality of uplink transmission power levels to be used for uplink transmission based on the received plurality of signal sequences; and transmitting an indication about the chosen uplink transmission power level to the client device.

An example embodiment of a computer program product comprises program code configured to perform the method according to any of the above example embodiments, when the computer program product is executed on a computer.

### DESCRIPTION OF THE DRAWINGS

The accompanying drawings, which are included to provide a further understanding of the example embodiments and constitute a part of this specification, illustrate example embodiments and together with the description help to explain the principles of the example embodiments. In the drawings:
Fig. 1 illustrates an example embodiment of the subject matter described herein illustrating a client device;
Fig. 2 illustrates an example embodiment of the subject matter described herein illustrating a network node device;
Fig. 3 illustrates estimated symbols and expected estimated symbols according to an example embodiment;
Fig. 4 illustrates estimated symbols and expected estimated symbols according to an example embodiment;
Fig. 5 illustrates estimated symbols and expected estimated symbols according to an example embodiment;
Fig. 6 illustrates estimated symbols and expected estimated symbols according to an example embodiment;
Fig. 7 illustrates estimated symbols and expected estimated symbols according to an example embodiment;
Fig. 8 illustrates estimated symbols and expected estimated symbols according to an example embodiment;
Fig. 9 illustrates symbols of a signal sequence according to an example embodiment;
Fig. 10 illustrates symbols of a signal sequence and estimated symbols according to an example embodiment;
Fig. 11 illustrates symbols of a signal sequence and estimated symbols according to an example embodiment;
Fig. 12 illustrates symbols of a signal sequence and estimated symbols according to an example embodiment;
Fig. 13 illustrates a schematic representation of a signaling diagram according to an example embodiment;
Fig. 14 illustrates a flow chart representation of a method according to an example embodiment;
Fig. 15 illustrates a flow chart representation of a method according to an example embodiment;
Fig. 16 illustrates symbols of a signal sequence and estimated symbols according to an example embodiment;
Fig. 17 illustrates symbols of a signal sequence and estimated symbols according to an example embodiment;
Fig. 18 illustrates symbols of a signal sequence and estimated symbols according to an example embodiment;
Fig. 19 illustrates symbols of a signal sequence and estimated symbols according to an example embodiment;
Fig. 20 illustrates symbols of a signal sequence and estimated symbols according to an example embodiment;
Fig. 21 illustrates symbols of a signal sequence and estimated symbols according to an example embodiment;
Fig. 22 illustrates symbols of a signal sequence and estimated symbols according to an example embodiment;
Fig. 23 illustrates symbols of a signal sequence and estimated symbols according to an example embodiment; and
Fig. 24 illustrates a schematic representation of an input to FFT after removing the cyclic prefix in the case of two client devices with delayed signals according to an example.

Like reference numerals are used to designate like parts in the accompanying drawings.

### DETAILED DESCRIPTION

Reference will now be made in detail to example embodiments, examples of which are illustrated in the accompanying drawings. The detailed description provided below in connection with the appended drawings is intended as a description of the present examples and is not intended to represent the only forms in which the present disclosure may be constructed or utilized. The description sets forth the functions of the example and the sequence of steps for constructing and operating the example. However, the same or equivalent functions and sequences may be accomplished by different example embodiments.

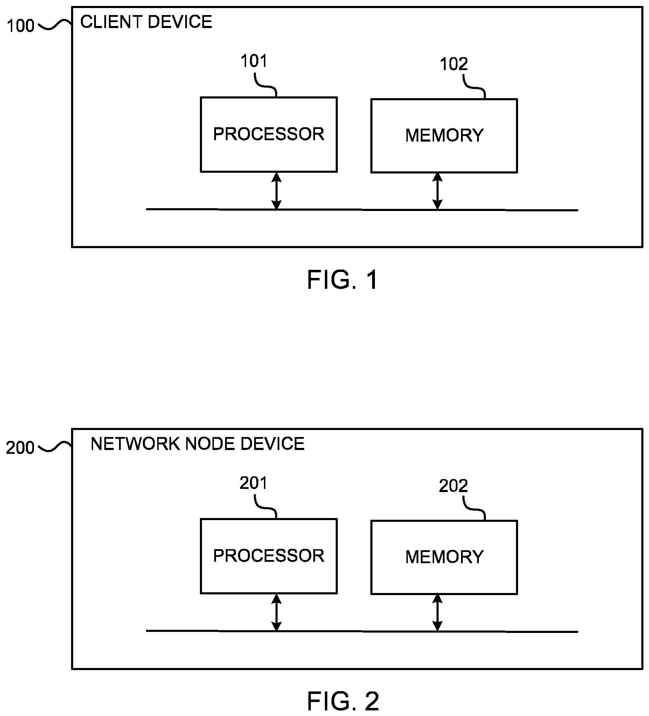

Fig. 1 is a block diagram of a client device 100 configured in accordance with an example embodiment.

The client device 100 may comprise one or more processors 101 and one or more memories 102 that comprise computer program code. The client device 100 may also comprise at least one antenna port, as well as other elements, such as an input/output module (not shown in Fig. 1), and/or a communication interface (not shown in Fig. 1).

According to an example embodiment, the at least one memory 102 and the computer program code are configured to, with the at least one processor 101, cause the client device 100 to obtain a signal sequence configuration defining a plurality of signal sequences, wherein each signal sequence in the plurality of signal sequences corresponds to an uplink transmission power level in a plurality of uplink transmission power levels.

Each signal sequence may comprise, for example, a pilot sequence, a reference signal sequence.

A signal sequence may also be referred to as a pilot sequence, a pilot signal sequence, a reference sequence, a reference signal sequence, or similar.

The plurality of signal sequences may be considered to form a combined signal sequence. Each signal sequence in the plurality of signal sequences may be referred to as a subsequence of such a combined signal sequence.

The at least one memory 102 and the computer program code may be further configured to, with the at least one processor 101, cause the client device 100 to transmit the plurality of signal sequences according to the signal sequence configuration to a network node device.

The client device 100 may transmit the plurality of signal sequences in any manner, such as those disclosed herein. For example, the plurality of signal sequences may be concatenated and/or interleaved with each other.

The at least one memory 102 and the computer program code may be further configured to, with the at least one processor 101, cause the client device 100 to receive, from the network node device, an indication about an uplink transmission power level out of the plurality of uplink transmission power levels to be used for uplink transmission.

The at least one memory 102 and the computer program code may be further configured to, with the at least one processor 101, cause the client device 100 to perform an uplink transmission using the indicated uplink transmission power level to the network node device.

According to an example embodiment, the at least one memory 102 and the computer program code are further configured to, with the at least one processor 101, cause the client device 100 to transmit the plurality of signal sequences in a physical random access channel preamble (PRACH).

For example, the signal sequence configuration may comprise and/or be embodied in a PRACH configuration.

In some example embodiments, the client device 100 may be configured to perform the functionality disclosed herein in response to specific signaling. For example the network node device may transmit such signaling. For example, if the network node device comprises at least one low-resolution analog-to-digital converter (ADC), the network node device can signal to the client device 100 that the functionality disclosed herein should be used to find the uplink transmission power level to be used for the uplink transmission.

Although the client device 100 may be depicted to comprise only one processor 101, the client device 100 may comprise more processors. In an example embodiment, the memory 102 is capable of storing instructions, such as an operating system and/or various applications.

According to an example embodiment, the uplink transmission corresponds to a channel, a channel associated with data, a channel associated with control, a signal, a reference signals, a data transmission and/or any combination thereof.

Furthermore, the processor 101 may be capable of executing the stored instructions. In an example embodiment, the processor 101 may be embodied as a multi-core processor, a single core processor, or a combination of one or more multi-core processors and one or more single core processors. For example, the processor 101 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, or the like. In an example embodiment, the processor 101 may be configured to execute hard-coded functionality. In an example embodiment, the processor 101 is embodied as an executor of software instructions, wherein the instructions may specifically configure the processor 101 to perform the algorithms and/or operations described herein when the instructions are executed.

The memory 102 may be embodied as one or more volatile memory devices, one or more non-volatile memory devices, and/or a combination of one or more volatile memory devices and non-volatile memory devices. For example, the memory 102 may be embodied as semiconductor memories (such as mask ROM, PROM (programmable ROM), EPROM (erasable PROM), flash ROM, RAM (random access memory), etc.).

The client device 100 may comprise, for example, user equipment (UE), a mobile phone, a smartphone, a tablet computer, a smart watch, or any hand-held or portable device or any other apparatus, such as a vehicle, a robot, or a repeater.

When the client device 100 is configured to implement some functionality, some component and/or components of the client device 100, such as the at least one processor 101 and/or the memory 102, may be configured to implement this functionality. Furthermore, when the at least one processor 101 is configured to implement some functionality, this functionality may be implemented using program code comprised, for example, in the memory 102. For example, if the client device 100 is configured to perform an operation, the at least one memory 102 and the computer program code can be configured to, with the at least one processor 101, cause the client device 100 to perform that operation.

Some terminology used herein may follow the naming scheme of 4G or 5G technology in its current form. However, this terminology should not be considered limiting, and the terminology may change over time. Thus, the following discussion regarding any example embodiment may also apply to other technologies.

Fig. 2 is a block diagram of a network node device 200 configured in accordance with an example embodiment.

The network node device 200 may comprise one or more processors 201 and one or more memories 202 that comprise computer program code. The network node device 200 may also comprise at least one antenna port, as well as other elements, such as an input/output module (not shown in Fig. 2), and/or a communication interface (not shown in Fig. 2).

According to an example embodiment, the at least one memory 202 and the computer program code are configured to, with the at least one processor 201, cause the network node device 200 to receive a plurality of signal sequences from a client device, wherein each signal sequence in the plurality of signal sequences corresponds to an uplink transmission power level in a plurality of uplink transmission power levels.

The at least one memory 202 and the computer program code may be further configured to, with the at least one processor 201, cause the network node device 200 to choose an uplink transmission power level out of the plurality of uplink transmission power levels to be used for uplink transmission based on the received plurality of signal sequences.

The network device 200 can, for example, choose the uplink transmission power level so that the network node device 200 can distinguish amplitude differences in the corresponding signal sequence while retaining an accurate phase estimation. Some example embodiments of how the network done device 200 can choose an appropriate uplink transmission power level are disclosed herein. Alternatively, network done device 200 can choose an appropriate uplink transmission power level in various other ways also.

The at least one memory 202 and the computer program code may be further configured to, with the at least one processor 201, cause the network node device 200 to transmit an indication about the chosen uplink transmission power level to the client device.

The network node device 200 may be further configured to receive an uplink transmission from the client device 100. The client device 100 may perform the uplink transmission using the chosen uplink transmission power level.

According to an example embodiment, the at least one memory 202 and the computer program code are further configured to, with the at least one processor 201, cause the network node device 200 to receive the plurality of signal sequences in a PRACH preamble.

Although the network node device 200 may be depicted to comprise only one processor 201, the network node device 200 may comprise more processors. In an example embodiment, the memory 202 is capable of storing instructions, such as an operating system and/or various applications.

Furthermore, the processor 201 may be capable of executing the stored instructions. In an example embodiment, the processor 201 may be embodied as a multi-core processor, a single core processor, or a combination of one or more multi-core processors and one or more single core processors. For example, the processor 201 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, or the like. In an example embodiment, the processor 201 may be configured to execute hard-coded functionality. In an example embodiment, the processor 201 is embodied as an executor of software instructions, wherein the instructions may specifically configure the processor 201 to perform the algorithms and/or operations described herein when the instructions are executed.

The memory 202 may be embodied as one or more volatile memory devices, one or more non-volatile memory devices, and/or a combination of one or more volatile memory devices and non-volatile memory devices. For example, the memory 202 may be embodied as semiconductor memories (such as mask ROM, PROM (programmable ROM), EPROM (erasable PROM), flash ROM, RAM (random access memory), etc.).

When the network node device 200 is configured to implement some functionality, some component and/or components of the network node device 200, such as the at least one processor 201 and/or the memory 202, may be configured to implement this functionality. Furthermore, when the at least one processor 201 is configured to implement some functionality, this functionality may be implemented using program code comprised, for example, in the memory 202. For example, if the network node device 200 is configured to perform an operation, the at least one memory 202 and the computer program code can be configured to, with the at least one processor 201, cause the network node device 200 to perform that operation.

The network node device may comprise, for example, a base station (BS), a next generation nodeB (gNB), or any such device providing an air interface for client devices to connect to the wireless network via wireless transmissions.

To support the exponential growth in mobile data traffic and meet the quality-of-service requirements of emerging wireless applications (such as autonomous mobility and augmented/mixed reality), beyond-5G systems are expected to exploit the large amount of bandwidth available in the sub-THz band (0.1-1 THz). This calls for truly massive arrays with thousands of fully digital antennas at the gNB. In this setting, the power consumed by each analog-to-digital/digital-to-analog converter (ADC/DAC) can scale linearly with the sampling rate and exponentially with the number of quantization bits.

Another limiting factor can be the volume of raw data exchanged between the remote radio head and the base-band unit, which can scale linearly with both the sampling rate and the number of quantization bits. For these reasons, adopting low-resolution ADCs/DACs (with, for example, 1 to 4 quantization bits) represents an attractive solution to drastically reduce the hardware power consumption and complexity at mmWave and sub-THz frequencies. Remarkably, even with few-bit data converters, fully digital architectures can outperform their hybrid analog-digital counterparts in terms of flexibility and energy efficiency and allow to achieve the large array and multiplexing gains promised by massive multiple-input multiple-output (MIMO).

According to an example embodiment, the network node device 200 further comprises at least one analog-to-digital converter with 1 - 10 quantization bits and the at least one memory 202 and the computer program code are further configured to, with the at least one processor 201, cause the network node device 200 to receive the data uplink transmission from the client device using the at least one analog-to-digital converter.

Alternatively, the at least one analog-to-digital converter may comprise, for example, 1 - 8 quantization bits, 1 - 6 quantization bits, 1 - 4 quantization bits, 1 - 2 quantization bits, 2 - 10 quantization bits, 2 - 8 quantization bits, 2 - 6 quantization bits, 2 - 4 quantization bits, or one quantization bit.

For example, each ADC may correspond to an antenna of the network node device 200. For example, the network node device 200 may comprise an array of digital antennas, such as fully digital antennas. Thus, each ADC may correspond to an antenna in a MIMO antenna array and/or a massive MIMO antenna array.

The extreme case of 1-bit ADCs/DACs, which only evaluate the sign of the input signal, can be particularly appealing at very high frequencies due to the minimal power consumption and complexity. In fact, it has been indicated that the necessary array and multiplexing gains can be achieved even with 1-bit resolution and, in presence of large bandwidths (such as tens of GHz, as available in the sub-THz band), there may be no need for high-order constellations such as 64 quadrature amplitude modulation (QAM). For example, 16-QAM or lower may be enough).

Operating with low-resolution ADCs/DACs can require higher granularity in the antenna domain for the data transmission and/or reception and in the time domain for the channel estimation. Furthermore, a proper operating signal-to-noise ratio (SNR) may be needed in order to minimize the performance loss due to the quantization. To visualize this, a case of 1-bit ADCs at the gNB can be considered while assuming that a single user equipment (UE) transmits 16-QAM data symbols in the uplink. Each data symbol is transmitted over the channel, received at each of the M antennas of the gNB with independent additive noise, and finally quantized. At this stage, the gNB applies a combining vector, such as a matched filter (MF), to the quantized signal to obtain an estimate of the transmitted data symbol. Hence, this estimate is a combination of M quantized noisy signals. On the one hand, a larger value of M corresponds to higher accuracy in the phase estimation. On the other hand, if the additive noise power is too low (i.e., high SNR), the gNB may not be able to recover the amplitude information.

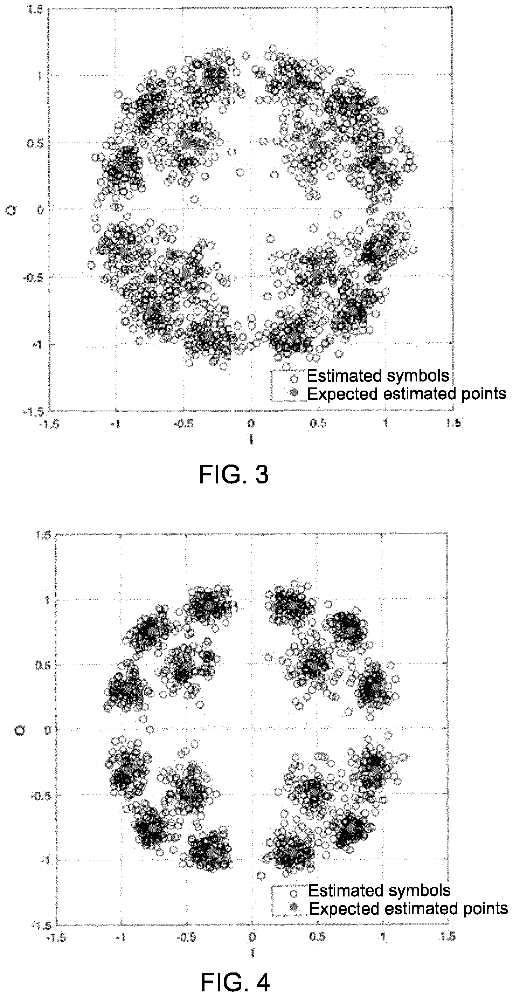

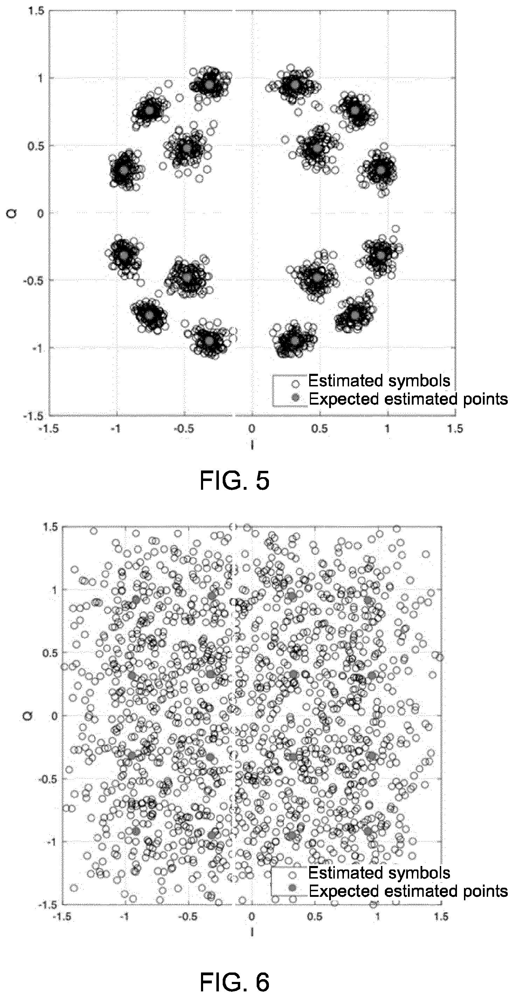

An illustrative example of the aforementioned situation is presented in Figs. 3 - 8. Figs. 3 - 5 illustrate estimated symbols with MF combining for different number of antennas. Figs. 6 - 8 illustrate estimated symbols with MF combining for different receive SNRs in the case of a single-UE and 1-bit ADCs. A similar trend can be observed for few-bit ADCs (such as with 2 to 4 quantization bits).

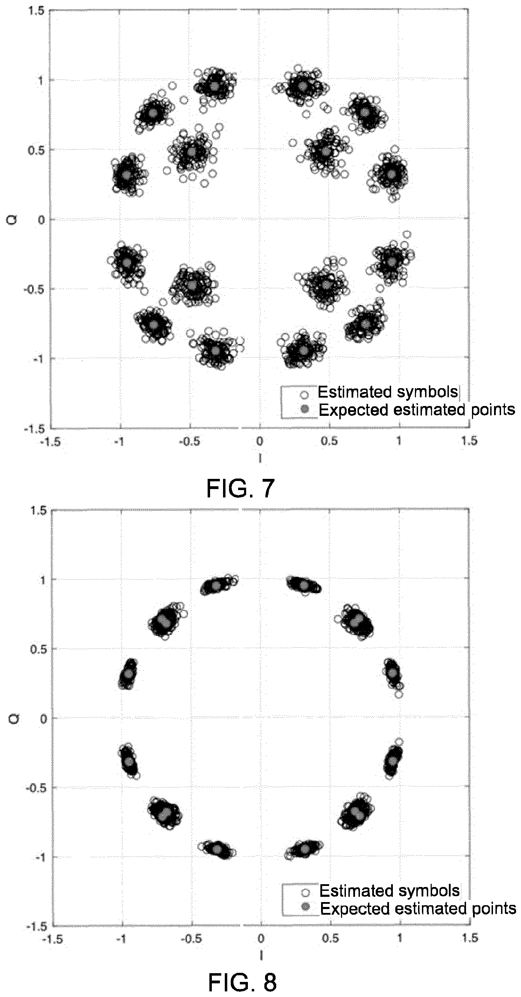

Fig. 3 corresponds to 32 gNB receiving antennas and an SNR of 5 dB. Fig. 4 corresponds to 64 gNB receiving antennas and an SNR of 5 dB. Fig. 5 corresponds to 128 gNB receiving antennas and an SNR of 5 dB. Fig. 6 corresponds to 128 gNB receiving antennas and an SNR of -10 dB. Fig. 7 corresponds to 128 gNB receiving antennas and an SNR of 5 dB. Fig. 8 corresponds to 128 gNB receiving antennas and an SNR of 20 dB.

Unlike traditional MIMO systems with high-resolution ADCs/DACs, where a high SNR is always desirable, low-resolution ADCs/DACs need to operate at the appropriate SNR level (not too low, not too high) in order to minimize the performance loss due to the quantization. This holds for both channel estimation and uplink/downlink data transmission. As illustrated in Figs. 3 - 8 for the case of uplink transmission of 16-QAM symbols, the decoding performance can depend on the operating SNR as follows:
- Too low SNR: the estimated symbols are corrupted by the strong noise (large dispersion around their expected values);
- Suitable SNR range: the phases are accurately estimated and the estimated symbols with the same phase get closer but can be well distinguished;
- Too high SNR: very accurate phase estimation, but the estimated symbols with the same phase are overlapping and, therefore, the amplitude information cannot be recovered.

According to an example embodiment, the at least one memory 202 and the computer program code are further configured to, with the at least one processor 201, cause the network node device 200 to choose the uplink transmission power level to be used for uplink transmission by performing: estimate each signal sequence in the plurality of signal sequences; and choose the uplink transmission power level by comparing each estimated signal sequence to a known signal sequence.

The known signal sequence may correspond to a signal sequence originally transmitted by the client device 100. Thus, by comparing each estimated signal sequence to the known signal sequence, the network node device 200 can evaluate how much the signal sequence has changed due to transmission and reception. These changes may comprise, for example, changes in the phase and/or amplitude of each symbol in the signal sequence.

The network node device 200 can, for example, choose the uplink transmission power level that corresponds to a signal sequence from which the network node device 200 can distinguish symbol amplitude differences while retaining an accurate phase estimation.

According to an example embodiment, the at least one memory 202 and the computer program code are further configured to, with the at least one processor 201, cause the network node device 200 to choose the uplink transmission power level to be used for uplink transmission by performing: compute a channel estimate for the client device based on the received plurality of signal sequences; compute a combining vector for the client device based on the channel estimate of the client device; estimate each signal sequence in the plurality of signal sequences based on the combining vector of the client device; and choose the uplink transmission power level by comparing each estimated signal sequence to a known signal sequence.

The client device 100 and the network node device 200 can achieve an appropriate SNR by adjusting the transmission power at the client device 100 so that the network node device 200 can distinguish the amplitude differences while retaining an accurate phase estimation.

The current 5G NR standard does not support any procedure to tune the operating SNR in the context of low-resolution ADCs. To enable the use of low-resolution ADCs, UE power ramping should continue beyond the minimum sufficient SNR and be adjusted to find a suitable operating SNR that allows the gNB to distinguish the amplitude differences while retaining an accurate phase estimation of the transmitted data symbols. Furthermore, the current 5G NR standard does not support multiple amplitude levels, which may be needed to recover the amplitude information after quantization. Thus, new PRACH formats and related UE procedures can be advantageous.

When considering low-resolution ADCs only at the gNB-side, there is no need to modify the client hardware. Thus, the functionality of the client device 100 as, for example, a new PRACH format, can be implemented via software changes. Such a new PRACH format can also coexist with an existing PRACH implementation. Using the already existing PRACH format may limit the client device 100 to only utilize phase-based modulations due to gNB-side amplitude uncertainty.

A proper tuning of the operating SNR will allow the gNB equipped with low-resolution ADCs to distinguish amplitude differences while retaining an accurate phase estimation in the uplink transmission. The client device 100 and the network node device can enable a transmission mechanism that allows to tune the operating SNR. The transmission mechanism can be implemented as, for example, a PRACH transmission mechanism comprising a PRACH configuration and transmission procedure. The network node device 200 can, for example, utilizes low-resolution ADCs by adjusting the uplink transmission power level at the client device 100.

The transmission power tuning performed by the client device 100 and the network node device 200 can be effectively integrated into channel estimation, so the two procedures do not need to be performed separately. The two operations could entail a significant additional overhead if carried out separately.

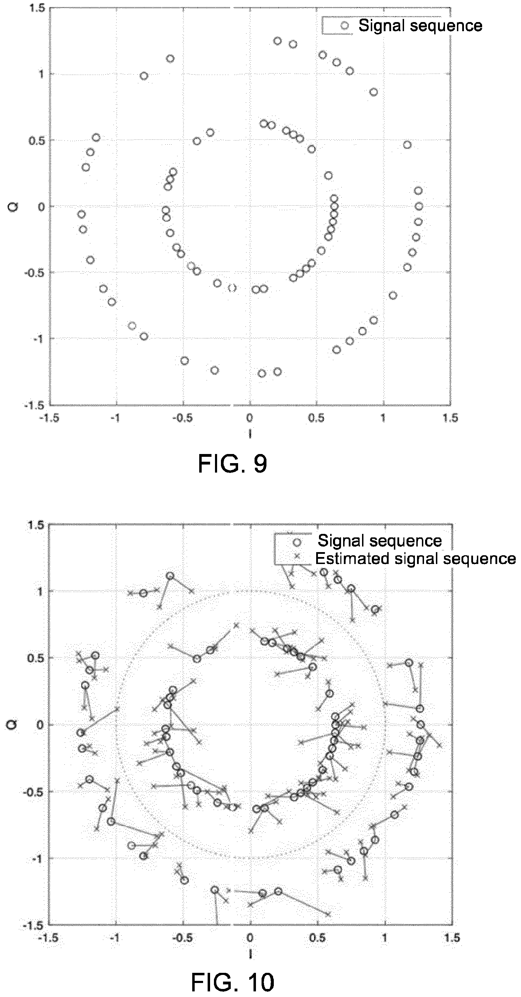

Fig. 9 illustrates symbols of a signal sequence according to an example embodiment.

According to an example embodiment, each signal sequence in the plurality of signal sequences corresponds to an amplitude-scaled version of a common signal sequence.

According to an example embodiment, the common signal sequence comprises a Zadoff-Chu signal sequence.

The example embodiment of Fig. 9 illustrates a signal sequence of length 134 with two different amplitudes obtained by concatenating the same Zadoff-Chu sequence of length 67 with different scalings.

The example embodiment of Fig. 10 illustrates the signal sequence of the example embodiment of Fig. 9 and the corresponding estimated signal sequence with 512 gNB receiving antennas and an SNR of -10 dB. The SNR is too low. Thus, the estimated signal sequences are corrupted by the strong noise.

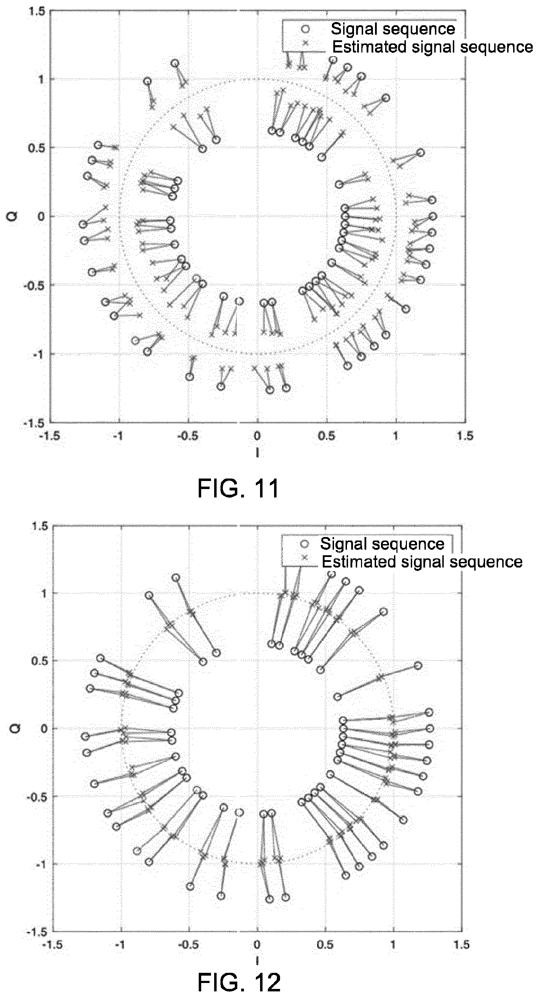

The example embodiment of Fig. 11 illustrates the signal sequence of the example embodiment of Fig. 9 and the corresponding estimated signal sequence with 512 gNB receiving antennas and an SNR of 5 dB. The SNR is suitable. Thus, the phases can be accurately estimated and the estimated symbols with different amplitudes can be well distinguished.

The example embodiment of Fig. 12 illustrates the signal sequence of the example embodiment of Fig. 9 and the corresponding estimated signal sequence with 512 gNB receiving antennas and an SNR of 20 dB. The SNR is too high. Thus, phase estimation is very accurate, but the estimated symbols lie on the unit circle. Thus, the amplitude information cannot be recovered.

According to an example embodiment, the at least one memory 102 and the computer program code are further configured to, with the at least one processor 101, cause the client device 100 to transmit the plurality of signal sequences according to the signal sequence configuration to the network node device 200 at predefined transmission time occasions.

The client device 100 may proactively and possibly simultaneously with other client devices transmit the signal sequences with different uplink transmission power levels. The network node device 200 can examine the phase accuracy and the amplitude differences of the estimated signal sequences obtained with the different uplink transmission power levels. The network node device 200 can choose the appropriate setting and inform the client device 100 about the uplink transmission power level to utilize during the uplink transmission.

Herein, proactive transmitting may mean that, instead of transmitting the signal sequences, such as in a PRACH preamble, and waiting for a response, such as a RACH response, the client device 100 can keep transmitting signal sequences with, for example, increasing power.

Compared with an existing power ramping process, the procedure performed by the client device 100 can be faster as it does not require feedback from the network before a new transmission with increased power. Additional waiting delays are possible. Further, the transmission power will not be greater. In fact, the opposite will usually occur, since the optimal SNR for the quantized transmission is usually lower than in the full-resolution case.

After examining the phase accuracy and the amplitude differences of the estimated signal sequences obtained with the different uplink transmission power levels, the network node device 200 can choose the appropriate setting. For example, in Figs. 10 - 12, the appropriate choice would be the uplink transmission power level corresponding to Fig. 11. This "sweet spot" in terms of SNR can correspond to minimizing the symbol error rate and is generally difficult to find analytically since it depends on system parameters such as the number of antennas, number of clients devices, and channel distribution. Hence, the client device 100 and the network node device 200 can find it empirically.

Although Figs. 10 - 12 consider the case of 1-bit ADCs, the procedure performed by the client device 100 and the network node device 200 and the discussion herein can apply equivalently to the case of few-bit ADCs, such as with 2 to 4 quantization bits.

The client device 100 can be configured with a signal sequence of a predefined length comprising symbols with a plurality of different amplitudes. This can allow to gauge the capability of the network node device 200 to distinguish amplitude differences at a given operating SNR.

The signal sequence can be known at the network node device 200. Furthermore, signal sequences configured for different client devices can possibly be orthogonal to each other to reduce pilot contamination.

According to an example embodiment, the plurality of signal sequences are interleaved and/or concatenated with each other.

Herein, interleaved may mean temporally interleaved. When two signal sequences are interleaved, symbols may be transmitted, for example, in an alternately manner from the two signal sequences. Alternatively, the transmitted symbols may alternate between the plurality of signal sequences in some other manner.

Herein, concatenated may mean temporally concatenated.

The symbols with different amplitudes can be arbitrarily interleaved within the signal sequence (concatenated or non-concatenated), which can be configured by the network node device 200. One example of such a signal sequence can be obtained by concatenating two properly scaled Zadoff-Chu sequences *r*₁ and *r*₂. For example, a combined signal sequence *q* may be obtained as *q =* [*α*₁ ** r*₁; *α*₂ **r*₂]*,* where [x;*y*] indicates the concatenation of sequences *x* and *y.* The amplitudes *α*₁ and *α*₂ should be chosen consistently with the amplitudes of the input constellation used for the uplink transmission.

The client device 100 can transmit the plurality of signal sequences with different uplink transmission power levels so that the network node device 200 can examine different operating SNRs.

According to an example embodiment, the at least one memory 102 and the computer program code are further configured to, with the at least one processor 101, cause the client device 100 to obtain the signal sequence configuration by receiving the signal sequence configuration from the network node device, and wherein the signal sequence configuration comprises a power range defining a minimum power and a maximum power for the plurality of signal sequences and a power ramping step for the plurality of signal sequences.

The power ramping step can define, for example, a power difference between a pair of signal sequences in the plurality of signal sequences. For example, each signal sequence in the plurality of signal sequences may correspond to a transmission power that is greater than a transmission power of the previous signal sequence and the power difference between two consecutive signal sequences may be equal to the power ramping step.

The different uplink transmission power levels can be set, for example, incrementally in the interval [pmin, pmax]. The transmission of the signal sequences by the client device 100 with each uplink transmission power level can be performed proactively at predefined transmission time occasions. Thus, the client device 100 may not wait for any signaling from the network node device 200 before transmitting the signal sequence with the next uplink transmission power level.

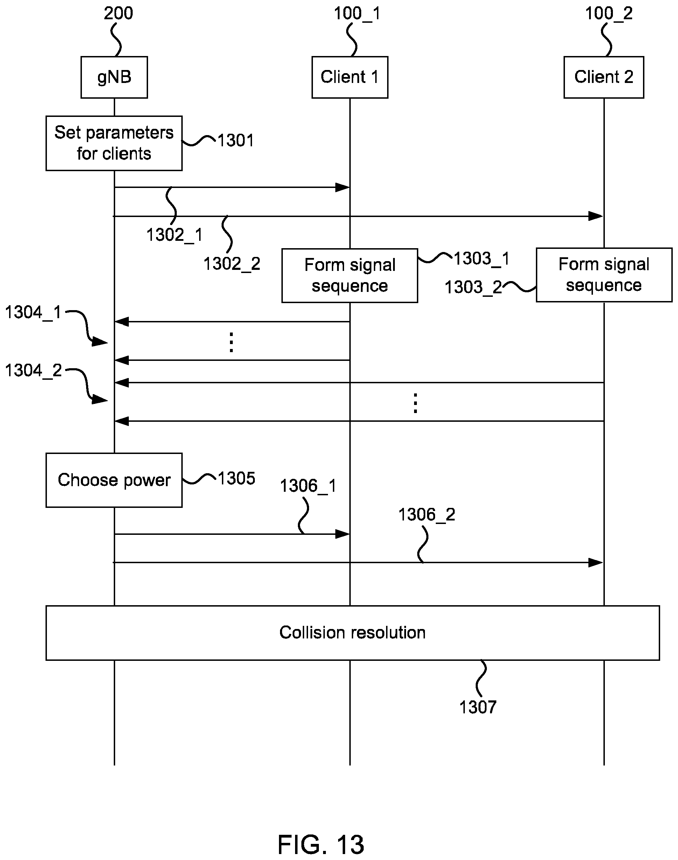

Fig. 13 illustrates a schematic representation of a signaling diagram according to an example embodiment.

The network node device 200, such as a gNB, can set 1301 the signal sequence configuration for at least one client device 100. The signal sequence configuration can define a transmission power range [*p*ₘᵢₙ, *p*ₘₐₓ], a transmission power ramping step Δ*p*, and/or signal sequences to be used by the at least one client device 100_1, 100_2.

For example, the transmission power of a first signal sequence in the plurality of signal sequences may be *p*₀ = *pₘᵢₙ.* Then, the transmission power of an nth signal sequence in the plurality of signal sequences may be *pₙ = p*_{*n-*1} + Δ*p**.*** The transmission power of the last signal sequence in the plurality of signal sequences may be *pₘₐₓ.* In other example embodiments, the signal sequences may be ordered in various other ways. For example, the order may be a reverse of the aforementioned. Alternatively or additionally, the signal sequence may be interleaved with each other, and therefore, the signal sequences may not have a clearly defined order.

According to an example embodiment, the at least one memory 202 and the computer program code are further configured to, with the at least one processor 201, cause the network node device 200 to transmit a signal sequence configuration defining the plurality of signal sequences to the client device.

The network node device 200 can transmit 1302_1, 1302_2 the signal sequence configuration to the at least one client device 100_1, 100_2. For example, the network node device 200 can transmit the signal sequence configuration to the at least one client device 100_1, 100_2 in System Information Block Type 1 (SIB1).

The at least one client device 100_1, 100_2 can form 1303_1, 1303_2 the plurality of signal sequences according to the signal sequence configuration. For example, the at least one client device 100_1, 100_2 can form the PRACH preamble.

Each client device 100_1, 100_2 can transmit the plurality of signal sequences 1304_1, 1304_2 to the network node device 200. For example, the at least one client device 100_1, 100_2 can transmit the PRACH preamble. The plurality of signal sequences 1304_1, 1304_2 may comprise, for example a signal sequence for each uplink transmission power level p = *p*ₘᵢₙ : Δ*p* : *p*ₘₐₓ. The at least one client device 100_1, 100_2 can transmit the plurality of signal sequences 1304_1, 1304_2 at the predefined time instances. If there are a plurality of client devices, each client device in the plurality of client devices can transmit simultaneously.

The network node device 200 can receive the plurality of signal sequences 1304_1, 1304_2 and, after quantization, can store them and compute a channel estimate for each client device 100. Based on the channel estimates, the network node device 200 can compute a combining vector for each client device 100_1, 100_2 and use it to estimate the corresponding signal sequence. The network node device 200 can compare the estimated signal sequences to a known signal sequence. The network node device 200 can measure the phase accuracy and the amplitude differences for each signal sequence in the plurality of signal sequences. The network node device 200 can examine the phase accuracy and the amplitude differences of the estimated signal sequences obtained with the different uplink transmission power levels and choose 1305 an appropriate uplink transmission power level.

The network node device 200 can inform 1306_1, 1306_2 the at least one client device 100_1, 100_2 about the uplink transmission power level to utilize during the uplink transmission. For example, the network node device 200 can transmit RACH response to each client device 100_1, 100_2 comprising the uplink transmission power level to utilize during the uplink transmission.

The network node device 200 and the at least one client device 100_1, 100_2 can perform collision resolution 1307 in order to perform the uplink transmission.

In the following, various example embodiments of the plurality of signal sequences are disclosed. These example embodiments are only exemplary, and the plurality of signal sequences may also be implemented in various other ways.

The plurality of signal sequences may comprise, for example, a signal sequence **r**₁ of length N repeated with two different amplitudes, α₁ and α₂. Each amplitude may correspond to a signal sequence in the plurality of signal sequences. The plurality of signal sequence may be considered to form a combined signal sequence of length 2N of the form [α₁***r**₁ α₂***r**₁]. Two different signal sequences **r**₁ and **r**₂ may also be used instead of the same sequence repeating **r**₁.

The plurality of signal sequences may comprise, for example, two signal sequences of length *N,* with different amplitude levels. The two signal sequences may be interleaved such that up to *P* symbols (with *P* < *N)* of the first signal sequence are transmitted followed by *P* symbols of the second signal sequence. This structure may be repeated until all the *P* symbols from both signal sequences are transmitted. For example, with *P* = 3, the plurality of signal sequences may be of the form [α₁***r**₁₁ α₁*r₁₂ α₁*r₁₃ α_{2*}r₂₁ α₂*r₂₂ α₂*r₂₃ α₁*r₁₄ α₁*r₁₅ α₁*r₁₆ ...].

There may be one or more symbols before the first signal sequence and/or after the last signal sequence that are not part of the plurality of signal sequences. These symbols may have zero amplitude and may or may not be used for transmission.

The plurality of signal sequences may be transmitted in any order and/or symbols from different signal sequences in the plurality of signal sequences may be interleaved.

Numerical simulations have shown that using a signal sequence with two power levels may allow to evaluate the capability of the network node device 200 to distinguish even higher-order constellations, such as 64-QAM (with 3 levels).

According to an example embodiment, the network node device 200 is configured to interrupt the transmission of the plurality of signal sequences. The network node device 200 may interrupt the transmission of the plurality of signal sequences, for example, in response to a signal sequence received by the network node device 200 in the plurality of signal sequences correspond to a satisfactory SNR or in response to the plurality of signal sequences starting to deteriorate. For example, a listening slot may be introduced every T signal sequence.

According to an example embodiment, network-configured random access occasions (ROs) are paired. Thus, each RO has a corresponding RO and this pair of ROs has the same corresponding Synchronization Signal Block (SSB). Paired ROs may be multiplexed in the frequency and/or time domain. The client device 100 may be configured to select the associated pair of ROs based on the SSB measurement. The client device 100 may transmit selected preamble from among the preambles configured for both ROs. There may also be pre-determined relationship between the selected preamble of the first RO and the second RO of the pair to lower the implementation complexity of the network node device 200 in the detection. Furthermore, the client device 100 may use the configured transmission power scaling for the preambles of the ROs in the selected RO pair.

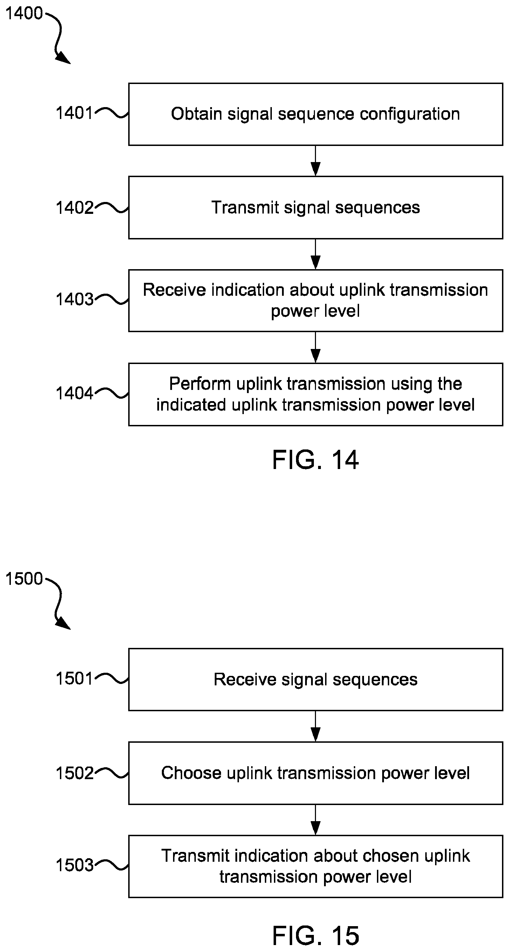

Fig. 14 illustrates a flow chart representation of a method according to an example embodiment.

According to an embodiment, a method 1400 comprises obtaining 1401 a signal sequence configuration defining a plurality of signal sequences, wherein each signal sequence in the plurality of signal sequences corresponds to an uplink transmission power level in a plurality of uplink transmission power levels.

The method 1400 may further comprise transmitting 1402 the plurality of signal sequences according to the signal sequence configuration to a network node device.

The method 1400 may further comprise receiving 1403, from the network node device, an indication about an uplink transmission power level out of the plurality of uplink transmission power levels to be used for uplink transmission.

The method 1400 may further comprise performing 1404 an uplink transmission using the indicated uplink transmission power level to the network node device.

The method 1400 may be performed by, for example, the client device 100.

Fig. 15 illustrates a flow chart representation of a method according to an example embodiment.

According to an embodiment, a method 1500 comprises receiving 1501 a plurality of signal sequences from a client device, wherein each signal sequence in the plurality of signal sequences corresponds to an uplink transmission power level in a plurality of uplink transmission power levels.

The method 1500 may further comprise choosing 1502 an uplink transmission power level out of the plurality of uplink transmission power levels to be used for uplink transmission based on the received plurality of signal sequences.

The method 1500 may further comprise transmitting 1503 an indication about the chosen uplink transmission power level to the client device.

The method 1500 may be performed by, for example, the network node device 200.

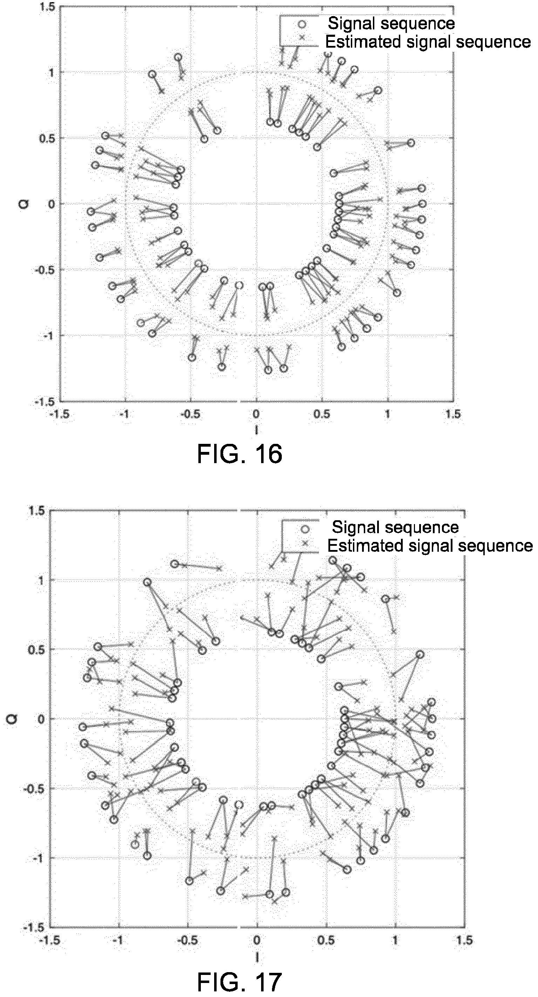

Fig. 16 and Fig. 17 illustrate simulation results for two client devices.

Figs. 16 and 17 illustrate estimated signal sequences for two client devices with 8 dB SNR imbalance and 1-bit ADCs at the gNB. Fig. 16 correspond to a first client device with 512 antennas at the gNB and an SNR of 5 dB and Fig. 17 corresponds to a second client device with 512 antennas at the gNB and an SNR of -3 dB.

The results of Figs. 16 and 17 correspond to the results illustrated in Figs. 9 - 12 but for two client devices. In case of significant SNR imbalances among the client devices 100, the performance of the client devices 100 with lower SNR may be degraded, as illustrated in Figs. 16 and 17 for two client devices 100. The procedure performed by the client device 100 and the network node device 200 can be complemented by a second UE-specific tuning stage during the closed-loop power control to compensate such SNR imbalances.

Results similar to Fig. 9 - 12 can be obtained for multiple client devices 100 when, after the open-loop power control, there are no significant SNR imbalances among the client devices 100. In this case, the transmission power tuning can be performed simultaneously at all the client devices 100.

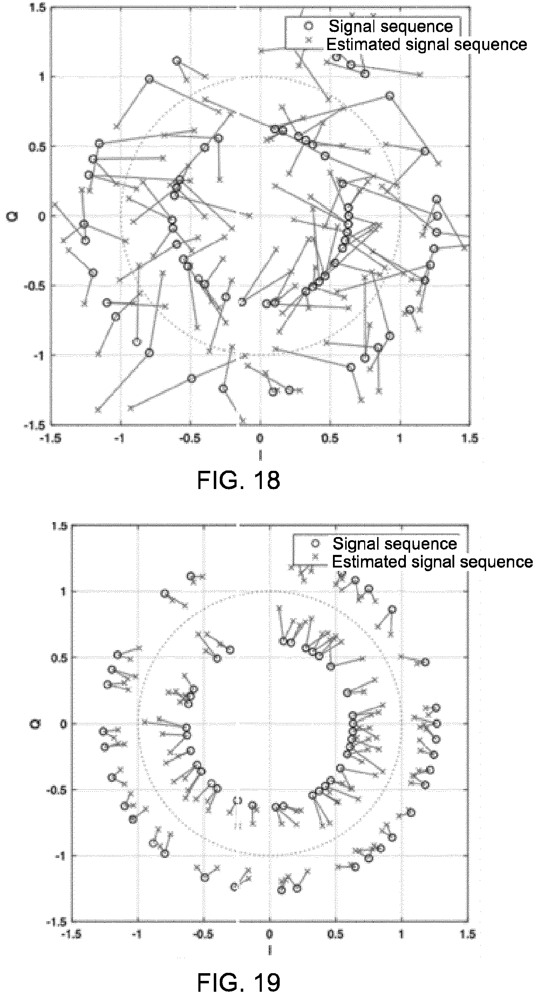

Fig. 18 - 20 illustrate simulation results for two-bit ADCs.

The procedure performed by the client device 100 and the network node device 200 can be applied to the case of few-bit ADCs, such as ADCs with 2 to 4 quantization bits. With more than 1 bit, the SNR (or transmission power) of each client device 100 may need to be tuned with respect to the quantization thresholds and levels adopted at the network node device 200. In this regard, Figs. 18 - 23 depict the simulation results with two-bit ADCs and three-bit ADCs.

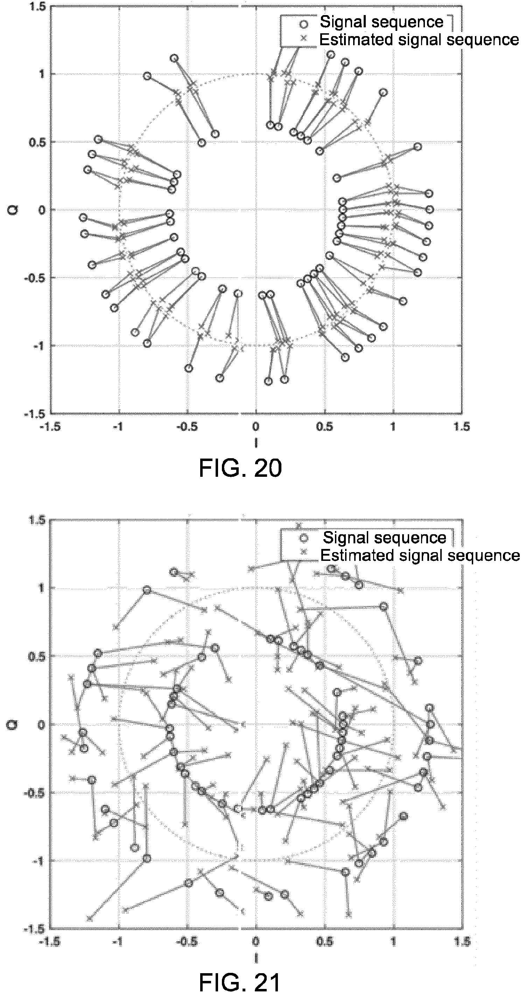

Fig. 18 correspond to 512 antennas at the gNB and an SNR of -10 dB, Fig. 19 correspond to 512 antennas at the gNB and an SNR of 5 dB, and Fig. 20 correspond to 512 antennas at the gNB and an SNR of 20 dB.

Fig. 21 - 23 illustrate simulation results for three-bit ADCs.

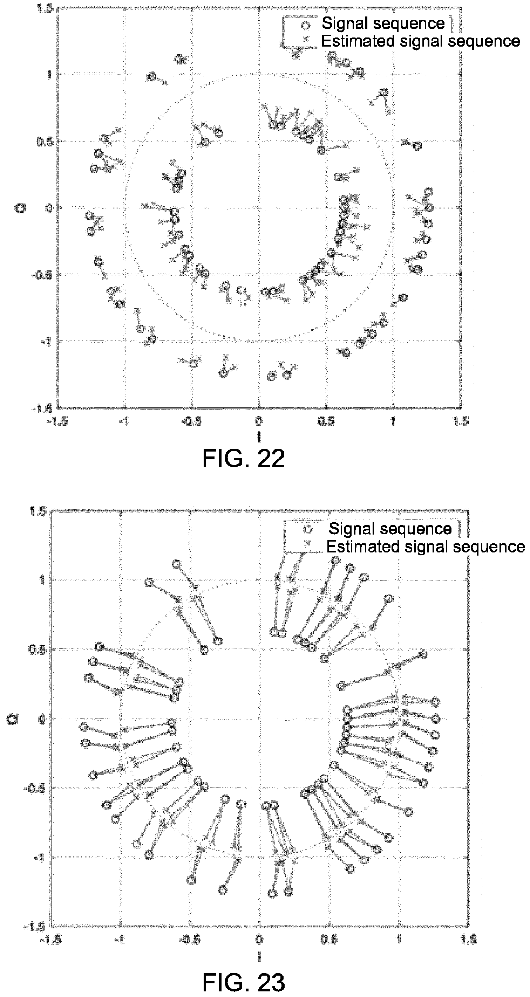

Fig. 21 correspond to 512 antennas at the gNB and an SNR of -10 dB, Fig. 22 correspond to 512 antennas at the gNB and an SNR of 5 dB, and Fig. 23 correspond to 512 antennas at the gNB and an SNR of 20 dB.

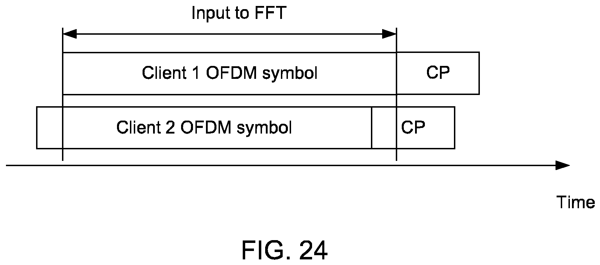

Fig. 24 illustrates a schematic representation of an input to FFT after removing the cyclic prefix in the case of two client devices with delayed signals according to an example.

In the following the effect of delay on the estimation accuracy and peak-to-average power ratio (PAPR) are discussed.

A system model where a network node device 200 is equipped with 512 antennas and serves two client devices 100 on 512 subcarriers is considered. A signal sequence ***q*** = **[1 * *r*₁; 0.5 * *r*₂]** depicted in the example of in Fig. 9 (with normalization) is considered. ***r***₁ and ***r***₂ are two Zadoff-Chu sequences of length 67 with a cyclic shift difference of 6. the signal sequence for the second client device 100 is obtained by means of additional cyclic shifts with respect to the signal sequence of the first client device 100 in order to ensure orthogonality. This provides a combined sequences that are robust against delay (i.e., frequency-domain cyclic shifts). The preamble sequences are situated in the middle of this bandwidth, i.e., there are frequency-domain guard bands on either side of the transmit signal. 4-fold oversampling is utilized for the PAPR investigation and delay modelling, where the oversampling allows the addition sub-integer delays to the time-domain signal of the second client device 100.

In the following the effect of delay on the estimation accuracy is discussed.

As it is unlikely that the signal time of arrival for both client devices 100 is the same, the effect of delay needs to be investigated. This is achieved by creating an oversampled time-domain signal (using oversampled OFDM modulation) and, after cyclic prefix (CP) insertion, by adding a delay to the signal of one client device 100. Then, as the receiver removes the CP based on the delayed client device 100, the other client device 100 signal experiences a circular time-domain shift. This shift causes a linear phase shift in the frequency domain, which should be compensated. By applying a proper phase correction, the network node device 200 can recover the same results as in Figs. 10 - 12. Larger delays cause cyclic shifts in the received frequency domain signal. However, as long as the cyclic shifts are smaller than the shifts between the Zadoff-Chu sequences (i.e., there is no overlap in the sequences), good estimates can be acquired.

One advantage of using Zadoff-Chu sequences is their low-PAPR property. The use of different amplitudes in the same random access preamble can slightly increase the PAPR, as it is no longer characterized by constant modulus. The example preamble sequence *q* mentioned above, as compared to one pure Zadoff-Chu sequence of length 139, increases the PAPR by around 1 dB if DFT-spreading is not used and around 1.5 dB if DFT-spreading is used. Thus, a penalty in the PAPR, and by corollary, the coverage where the preamble is detectable, is to be expected. However, as it is unlikely that cell-edge client devices 100 can utilize constellations with multiple amplitude levels, such as 16-QAM and higher order QAM, the final preamble transmissions during power ramping can use sequences with a single amplitude level. This can bypass the PAPR penalty in the extreme case where it would be highly unbeneficial.

An apparatus may comprise means for performing any aspect of the method(s) described herein. According to an example embodiment, the means comprise at least one processor, and memory comprising program code, the at least one processor, and program code configured to, when executed by the at least one processor, cause performance of any aspect of the method.

The functionality described herein can be performed, at least in part, by one or more computer program product components such as software components. According to an example embodiment, the client device 100 and/or the network node device 200 comprises a processor configured by the program code when executed to execute the example embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), and Graphics Processing Units (GPUs).

Any range or device value given herein may be extended or altered without losing the effect sought. Also any example embodiment may be combined with another example embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims.

It will be understood that the benefits and advantages described above may relate to one example embodiment or may relate to several example embodiments. The example embodiments are not limited to those that solve any or all of the stated problems or those that have any or all of the stated benefits and advantages. It will further be understood that reference to 'an' item may refer to one or more of those items.

The steps of the methods described herein may be carried out in any suitable order, or simultaneously where appropriate. Additionally, individual blocks may be deleted from any of the methods without departing from the scope of the subject matter described herein. Aspects of any of the example embodiments described above may be combined with aspects of any of the other example embodiments described to form further example embodiments without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various example embodiments have been described above with a certain degree of particularity, or with reference to one or more individual example embodiments, those skilled in the art could make numerous alterations to the disclosed example embodiments without departing from the scope of this specification.

## Claims

1. A client device (100), wherein the client device (100) comprises:
means for obtaining a signal sequence configuration defining a plurality of signal sequences, wherein each signal sequence in the plurality of signal sequences corresponds to an uplink transmission power level in a plurality of uplink transmission power levels;
means for transmitting the plurality of signal sequences according to the signal sequence configuration to a network node device;
means for receiving, from the network node device, an indication about an uplink transmission power level out of the plurality of uplink transmission power levels to be used for uplink transmission; and
means for performing an uplink transmission using the indicated uplink transmission power level to the network node device.

2. The client device (100) according to claim 1, wherein the plurality of signal sequences are interleaved and/or concatenated with each other.

3. The client device (100) according to any preceding claim, wherein each signal sequence in the plurality of signal sequences corresponds to an amplitude-scaled version of a common signal sequence.

4. The client device (100) according to any preceding claim, wherein the uplink transmission corresponds to a channel, a channel associated with data, a channel associated with control, a signal, a reference signals, a data transmission and/or any combination thereof.

5. The client device (100) according to any preceding claim, further comprising means for transmitting the plurality of signal sequences in a physical random access channel preamble.

6. The client device (100) according to any preceding claim, further comprising means for transmitting the plurality of signal sequences according to the signal sequence configuration to the network node device at predefined transmission time occasions.

7. The client device (100) according to any preceding claim, further comprising means for obtaining the signal sequence configuration by receiving the signal sequence configuration from the network node device, and wherein the signal sequence configuration comprises an uplink transmission power range defining a minimum power and a maximum power for the plurality of signal sequences and a power ramping step for the plurality of signal sequences.

8. A network node device (200), wherein the network node device (200) comprises:
means for receiving a plurality of signal sequences from a client device, wherein each signal sequence in the plurality of signal sequences corresponds to an uplink transmission power level in a plurality of uplink transmission power levels;
means for choosing an uplink transmission power level out of the plurality of uplink transmission power levels to be used for uplink transmission based on the received plurality of signal sequences; and
means for transmitting an indication about the chosen uplink transmission power level to the client device.

9. The network node device according to claim 8, further comprising means for choosing the uplink transmission power level to be used for uplink transmission by performing:
estimating each signal sequence in the plurality of signal sequences; and
choosing the uplink transmission power level by comparing each estimated signal sequence to a known signal sequence.

10. The network node device according to claim 8 or claim 9, further comprising means for choosing the uplink transmission power level to be used for uplink transmission by performing:
computing a channel estimate for the client device based on the received plurality of signal sequences;
computing a combining vector for the client device based on the channel estimate of the client device;
estimating each signal sequence in the plurality of signal sequences based on the combining vector of the client device; and
choosing the uplink transmission power level by comparing each estimated signal sequence to a known signal sequence.

11. The network node device (200) according to any of claims 8 - 10, wherein the network node device further comprises at least one analog-to-digital converter with 1 - 10 quantization bits and further comprises means for receiving the uplink transmission from the client device using the at least one analog-to-digital converter.

12. The network node device according to any of claims 8 - 11, further comprising means for transmitting a signal sequence configuration defining the plurality of signal sequences to the client device.

13. A method (1400), wherein the method (1400) comprises:
obtaining (1401) a signal sequence configuration defining a plurality of signal sequences, wherein each signal sequence in the plurality of signal sequences corresponds to an uplink transmissions power level in a plurality of uplink transmission power levels;
transmitting (1402) the plurality of signal sequences according to the signal sequence configuration to a network node device;
receiving (1403), from the network node device, an indication about an uplink transmission power level out of the plurality of uplink transmission power levels to be used for uplink transmission; and
performing (1404) an uplink transmission using the indicated uplink transmission power level to the network node device.

14. A method (1500), wherein the method (1500) comprises:
receiving (1501) a plurality of signal sequences from a client device, wherein each signal sequence in the plurality of signal sequences corresponds to an uplink transmission power level in a plurality of uplink transmission power levels;
choosing (1502) an uplink transmission power level out of the plurality of uplink transmission power levels to be used for uplink transmission based on the received plurality of signal sequences; and
transmitting (1503) an indication about the chosen uplink transmission power level to the client device.

15. A computer program product comprising program code configured to perform the method according to claim 13 or claim 14, when the computer program product is executed on a computer.

## Patentansprüche

1. Client-Vorrichtung (100), wobei die Client-Vorrichtung (100) umfasst:
Mittel zum Erhalten einer Signalsequenzkonfiguration, die eine Vielzahl von Signalsequenzen definiert, wobei jede Signalsequenz in der Vielzahl von Signalsequenzen einem Uplink-Übertragungsleistungspegel in einer Vielzahl von Uplink-Übertragungsleistungspegeln entspricht;
Mittel zum Übertragen der Vielzahl von Signalsequenzen gemäß der Signalsequenzkonfiguration an eine Netzwerkknotenvorrichtung;
Mittel zum Empfangen, von der Netzwerkknotenvorrichtung, einer Angabe über einen Uplink-Übertragungsleistungspegel aus der Vielzahl von Uplink-Übertragungsleistungspegeln, der für eine Uplink-Übertragung zu verwenden ist; und
Mittel zum Durchführen einer Uplink-Übertragung unter Verwendung des angegebenen Uplink-Übertragungsleistungspegels an die Netzwerkknotenvorrichtung.

2. Client-Vorrichtung (100) nach Anspruch 1, wobei die Vielzahl von Signalsequenzen miteinander verschachtelt und/oder verkettet sind.

3. Client-Vorrichtung (100) nach einem der vorhergehenden Ansprüche, wobei jede Signalsequenz in der Vielzahl von Signalsequenzen einer amplitudenskalierten Version einer gemeinsamen Signalsequenz entspricht.

4. Client-Vorrichtung (100) nach einem der vorhergehenden Ansprüche, wobei die Uplink-Übertragung einem Kanal, einem mit Daten assoziierten Kanal, einem mit Steuerung assoziierten Kanal, einem Signal, Referenzsignalen, einer Datenübertragung und/oder einer beliebigen Kombination davon entspricht.

5. Client-Vorrichtung (100) nach einem der vorhergehenden Ansprüche, ferner umfassend Mittel zum Übertragen der Vielzahl von Signalsequenzen in einer physischen Direktzugriffskanalspräambel.

6. Client-Vorrichtung (100) nach einem der vorhergehenden Ansprüche, ferner umfassend Mittel zum Übertragen der Vielzahl von Signalsequenzen gemäß der Signalsequenzkonfiguration an die Netzwerkknotenvorrichtung zu vordefinierten Übertragungszeitpunkten.

7. Client-Vorrichtung (100) nach einem der vorhergehenden Ansprüche, ferner umfassend Mittel zum Erhalten der Signalsequenzkonfiguration durch Empfangen der Signalsequenzkonfiguration von der Netzwerkknotenvorrichtung, und wobei die Signalsequenzkonfiguration einen Uplink-Übertragungsleistungsbereich umfasst, der eine Mindestleistung und eine Höchstleistung für die Vielzahl von Signalsequenzen definiert, sowie eine Leistungsstufenschrittweite für die Vielzahl von Signalsequenzen.

8. Netzwerkknotenvorrichtung (200), wobei die Netzwerkknotenvorrichtung (200) umfasst:
Mittel zum Empfangen einer Vielzahl von Signalsequenzen von einer Client-Vorrichtung, wobei jede Signalsequenz in der Vielzahl von Signalsequenzen einem Uplink-Übertragungsleistungspegel in einer Vielzahl von Uplink-Übertragungsleistungspegeln entspricht;
Mittel zum Auswählen eines Uplink-Übertragungsleistungspegels aus der Vielzahl von Uplink-Übertragungsleistungspegeln, der für eine Uplink-Übertragung zu verwenden ist, basierend auf der empfangenen Vielzahl von Signalsequenzen; und
Mittel zum Übertragen einer Angabe über den ausgewählten Uplink-Übertragungsleistungspegel an die Client-Vorrichtung.

9. Netzwerkknotenvorrichtung nach Anspruch 8, ferner umfassend Mittel zum Auswählen des Uplink-Übertragungsleistungspegels, der für eine Uplink-Übertragung zu verwenden ist, durch Durchführen von:
Schätzen jeder Signalsequenz in der Vielzahl von Signalsequenzen; und
Auswählen des Uplink-Übertragungsleistungspegels durch Vergleichen jeder geschätzten Signalsequenz mit einer bekannten Signalsequenz.

10. Netzwerkknotenvorrichtung nach Anspruch 8 oder Anspruch 9, ferner umfassend Mittel zum Auswählen des Uplink-Übertragungsleistungspegels, der für eine Uplink-Übertragung zu verwenden ist, durch Durchführen von:
Berechnen einer Kanalschätzung für die Client-Vorrichtung basierend auf der empfangenen Vielzahl von Signalsequenzen;
Berechnen eines Kombinationsvektors für die Client-Vorrichtung basierend auf der Kanalschätzung der Client-Vorrichtung;
Schätzen jeder Signalsequenz in der Vielzahl von Signalsequenzen basierend auf dem Kombinationsvektor der Client-Vorrichtung; und
Auswählen des Uplink-Übertragungsleistungspegels durch Vergleichen jeder geschätzten Signalsequenz mit einer bekannten Signalsequenz.

11. Netzwerkknotenvorrichtung (200) nach einem der Ansprüche 8 bis 10, wobei die Netzwerkknotenvorrichtung ferner mindestens einen Analog-Digital-Wandler mit 1 bis 10 Quantisierungsbits umfasst und ferner Mittel zum Empfangen der Uplink-Übertragung von der Client-Vorrichtung unter Verwendung des mindestens einen Analog-Digital-Wandlers umfasst.

12. Netzwerkknotenvorrichtung nach einem der Ansprüche 8 bis 11, ferner umfassend Mittel zum Übertragen einer Signalsequenzkonfiguration, die die Vielzahl von Signalsequenzen definiert, an die Client-Vorrichtung.

13. Verfahren (1400), wobei das Verfahren (1400) umfasst:
Erhalten (1401) einer Signalsequenzkonfiguration, die eine Vielzahl von Signalsequenzen definiert, wobei jede Signalsequenz in der Vielzahl von Signalsequenzen einem Uplink-Übertragungsleistungspegel in einer Vielzahl von Uplink-Übertragungsleistungspegeln entspricht;
Übertragen (1402) der Vielzahl von Signalsequenzen gemäß der Signalsequenzkonfiguration an eine Netzwerkknotenvorrichtung;
Empfangen (1403), von der Netzwerkknotenvorrichtung, einer Angabe über einen Uplink-Übertragungsleistungspegel aus der Vielzahl von Uplink-Übertragungsleistungspegeln, der für eine Uplink-Übertragung zu verwenden ist; und
Durchführen (1404) einer Uplink-Übertragung unter Verwendung des angegebenen Uplink-Übertragungsleistungspegels an die Netzwerkknotenvorrichtung.

14. Verfahren (1500), wobei das Verfahren (1500) umfasst:
Empfangen (1501) einer Vielzahl von Signalsequenzen von einer Client-Vorrichtung, wobei jede Signalsequenz in der Vielzahl von Signalsequenzen einem Uplink-Übertragungsleistungspegel in einer Vielzahl von Uplink-Übertragungsleistungspegeln entspricht;
Auswählen (1502) eines Uplink-Übertragungsleistungspegels aus der Vielzahl von Uplink-Übertragungsleistungspegeln, der für eine Uplink-Übertragung zu verwenden ist, basierend auf der empfangenen Vielzahl von Signalsequenzen; und
Übertragen (1503) einer Angabe über den ausgewählten Uplink-Übertragungsleistungspegel an die Client-Vorrichtung.

15. Computerprogrammprodukt, umfassend Programmcode, der konfiguriert ist, das Verfahren nach Anspruch 13 oder Anspruch 14 auszuführen, wenn das Computerprogrammprodukt auf einem Computer ausgeführt wird.

## Revendications

1. Dispositif client (100), dans lequel le dispositif client (100) comprend :
des moyens pour obtenir une configuration de séquence de signaux définissant une pluralité de séquences de signaux, dans lequel chaque séquence de signaux dans la pluralité de séquences de signaux correspond à un niveau de puissance de transmission en liaison montante dans une pluralité de niveaux de puissance de transmission en liaison montante ;
des moyens pour transmettre la pluralité de séquences de signaux selon la configuration de séquence de signaux à un dispositif de nœud de réseau ;
des moyens pour recevoir, du dispositif de nœud de réseau, une indication concernant un niveau de puissance de transmission en liaison montante parmi la pluralité de niveaux de puissance de transmission en liaison montante devant être utilisé pour une transmission en liaison montante ; et
des moyens pour effectuer une transmission en liaison montante en utilisant le niveau de puissance de transmission en liaison montante indiqué vers le dispositif de nœud de réseau.

2. Dispositif client (100) selon la revendication 1, dans lequel la pluralité de séquences de signaux sont entrelacées et/ou concaténées les unes avec les autres.

3. Dispositif client (100) selon une quelconque revendication précédente, dans lequel chaque séquence de signaux dans la pluralité de séquences de signaux correspond à une version mise à l'échelle en amplitude d'une séquence de signaux commune.

4. Dispositif client (100) selon une quelconque revendication précédente, dans lequel la transmission en liaison montante correspond à un canal, un canal associé à des données, un canal associé à une commande, un signal, des signaux de référence, une transmission de données et/ou toute combinaison de ceux-ci.

5. Dispositif client (100) selon une quelconque revendication précédente, comprenant en outre des moyens pour transmettre la pluralité de séquences de signaux dans un préambule de canal d'accès aléatoire physique.

6. Dispositif client (100) selon une quelconque revendication précédente, comprenant en outre des moyens pour transmettre la pluralité de séquences de signaux selon la configuration de séquence de signaux au dispositif de nœud de réseau à des occasions de temps de transmission prédéfinies.

7. Dispositif client (100) selon une quelconque revendication précédente, comprenant en outre des moyens pour obtenir la configuration de séquence de signaux en recevant la configuration de séquence de signaux du dispositif de nœud de réseau, et dans lequel la configuration de séquence de signaux comprend une plage de puissance de transmission en liaison montante définissant une puissance minimale et une puissance maximale pour la pluralité de séquences de signaux et un pas d'échelonnement de puissance pour la pluralité de séquences de signaux.

8. Dispositif de nœud de réseau (200), dans lequel le dispositif de nœud de réseau (200) comprend :
des moyens pour recevoir une pluralité de séquences de signaux d'un dispositif client, dans lequel chaque séquence de signaux dans la pluralité de séquences de signaux correspond à un niveau de puissance de transmission en liaison montante dans une pluralité de niveaux de puissance de transmission en liaison montante ;
des moyens pour choisir un niveau de puissance de transmission en liaison montante parmi la pluralité de niveaux de puissance de transmission en liaison montante devant être utilisé pour une transmission en liaison montante en fonction de la pluralité de séquences de signaux reçue ; et
des moyens pour transmettre une indication concernant le niveau de puissance de transmission en liaison montante choisi au dispositif client.

9. Dispositif de nœud de réseau selon la revendication 8, comprenant en outre des moyens pour choisir le niveau de puissance de transmission en liaison montante devant être utilisé pour une transmission en liaison montante en effectuant :
une estimation de chaque séquence de signaux dans la pluralité de séquences de signaux ; et
un choix du niveau de puissance de transmission en liaison montante en comparant chaque séquence de signaux estimée à une séquence de signaux connue.

10. Dispositif de nœud de réseau selon la revendication 8 ou la revendication 9, comprenant en outre des moyens pour choisir le niveau de puissance de transmission en liaison montante devant être utilisé pour une transmission en liaison montante en effectuant :
un calcul d'une estimation de canal pour le dispositif client en fonction de la pluralité de séquences de signaux reçue ;
un calcul d'un vecteur de combinaison pour le dispositif client en fonction de l'estimation de canal du dispositif client ;
une estimation de chaque séquence de signaux dans la pluralité de séquences de signaux en fonction du vecteur de combinaison du dispositif client ; et
un choix du niveau de puissance de transmission en liaison montante en comparant chaque séquence de signaux estimée à une séquence de signaux connue.

11. Dispositif de nœud de réseau (200) selon l'une quelconque des revendications 8 à 10, dans lequel le dispositif de nœud de réseau comprend en outre au moins un convertisseur analogique-numérique avec 1 à 10 bits de quantification et comprend en outre des moyens pour recevoir la transmission en liaison montante du dispositif client en utilisant l'au moins un convertisseur analogique-numérique.

12. Dispositif de nœud de réseau selon l'une quelconque des revendications 8 à 11, comprenant en outre des moyens pour transmettre une configuration de séquence de signaux définissant la pluralité de séquences de signaux au dispositif client.

13. Procédé (1400), dans lequel le procédé (1400) comprend :
l'obtention (1401) d'une configuration de séquence de signaux définissant une pluralité de séquences de signaux, dans lequel chaque séquence de signaux dans la pluralité de séquences de signaux correspond à un niveau de puissance de transmission en liaison montante dans une pluralité de niveaux de puissance de transmission en liaison montante ;
la transmission (1402) de la pluralité de séquences de signaux selon la configuration de séquence de signaux à un dispositif de nœud de réseau ;
la réception (1403), du dispositif de nœud de réseau, d'une indication concernant un niveau de puissance de transmission en liaison montante parmi la pluralité de niveaux de puissance de transmission en liaison montante devant être utilisé pour une transmission en liaison montante ; et
l'exécution (1404) d'une transmission en liaison montante en utilisant le niveau de puissance de transmission en liaison montante indiqué vers le dispositif de nœud de réseau.

14. Procédé (1500), dans lequel le procédé (1500) comprend :
la réception (1501) d'une pluralité de séquences de signaux d'un dispositif client, dans lequel chaque séquence de signaux dans la pluralité de séquences de signaux correspond à un niveau de puissance de transmission en liaison montante dans une pluralité de niveaux de puissance de transmission en liaison montante ;
le choix (1502) d'un niveau de puissance de transmission en liaison montante parmi la pluralité de niveaux de puissance de transmission en liaison montante devant être utilisé pour une transmission en liaison montante en fonction de la pluralité de séquences de signaux reçue ; et
la transmission (1503) d'une indication concernant le niveau de puissance de transmission en liaison montante choisi au dispositif client.

15. Produit de programme informatique comprenant un code de programme configuré pour exécuter le procédé selon la revendication 13 ou la revendication 14, lorsque le produit de programme informatique est exécuté sur un ordinateur.
